# EUROPEAN PATENT SPECIFICATION

(11) **EP 0 260 906 B1**
(45) Date of publication and mention of the grant of the patent: **10.03.1993**
(21) Application number: 87308090.7
(22) Date of filing: 14.09.1987
(51) Int. Cl.: H01L 21/90, H01L 21/318, H01L 23/532

(54) **Method of producing semiconductor device and semiconductor device**
Verfahren zum Herstellen einer Halbleitervorrichtung und Halbleitervorrichtung
Procédé de fabrication d'un dispositif semi-conducteur, et dispositif semi-conducteur

(30) Priority: 17.09.1986 JP 218320/86; 31.08.1987 JP 217384/87
(43) Date of publication of application: 23.03.1988
(73) Proprietor: FUJITSU LIMITED, Kawasaki-shi, Kanagawa 211 (JP)
(72) Inventor: Hoshino, Kazuhiro, Meguro-ku Tokyo, 153 (JP); Inoue, Minoru, Kawasaki-shi Kanagawa, 213 (JP)
(74) Representative: Billington, Lawrence Emlyn

(56) References cited:
- EP-A- 0 128 102
- JP-A-53 116 089
- US-A- 4 429 011
- THIN SOLID FILMS, vol. 69, no. 1, June 1980, pages 379-386, Elsevier Sequoia, Lausanne, CH; R.J. MILLER et al.: "Electromigration in gold and copper thin film conductors"
- IBM TECHNICAL DISCLOSURE BULLETIN, vol. 15, no. 4, September 1972, page 1088, New York, US; J.E. ORDONEZ: "Protective coatings against corrosion in metal electrodes"

## Description

The present invention generally relates to a method of producing a semiconductor device. The present invention more particularly relates to a method of producing a semiconductor device using copper or copper alloy as a wiring or metallization material.

As well known, a metallization pattern of a large-scale integrated circuit (LSI) diminishes in width as its integration density increases. Although aluminium (Al) metallization is widely used for semiconductor chips,its width for metallization is limited to the range of 0.5 to 0.6 µm. This is because electromigration increasingly occurs as the aluminium metallization pattern becomes narrower. For this reason, use of a metallic material of a high melting point such as molybdenum (Mo) or tungsten (W) in place of Al has been considered. However, the resistivity of Mo or W is approximately twice the resistivity of Al in bulk and is more in a thin film. Therefore, a metallization material having a high electromigration resistance and a low resistivity is currently being investigated.

Presently, copper (Cu) is being investigated for metallization of LSIs due to its better electromigration resistance and lower resistivity than Al. A conventional semiconductor device with copper metallization is designed so that a copper metallization film is directly deposited on an insulating film such as silicon dioxide (SiO₂) which is deposited on a silicon (Si) substrate and over contact holes formed in the insulating film so as to be positioned on the top of diffused layers formed in the Si substrate. Of course, the copper film is patterned in accordance with the wiring pattern.

The semiconductor device thus produced is generally annealed at a high temperature of the order of 400°C or over in order to grow grains of Cu and to thereby improve the electromigration resistance. Thereafter, an insulating film is deposited on the Cu metallization film as well as the insulating film. The deposition of the insulating film is conventionally carried out by chemical vapour deposition (CVD) at a temperature of approximately 420°C. The insulating film on the copper metallization film may be made of, for example, phosphor-silicate glass (PSG), silicon nitride (Si₃N₄) or SiO₂. The insulating film acts as a passivation film or a layer-to-layer insulating film in multilevel interconnections.

However, there are disadvantages with the conventional method of producing a semiconductor device with the Cu metallization mentioned above. That is, the oxidation temperature of Cu ranges from 200 to 250°C, whereas the heat-treating temperature in the CVD process is of the order of 400°C or over. Therefore, Cu in the metallization film is easily oxidised due to oxygen which exists in an ambient atmosphere when depositing the insulating film by the CVD process. Oxidation of Cu damages the surface of the metallization film which is in contact with the insulation film and therefore degrades the Cu metallization film, especially in terms of its resistance.

A paper in Thin Solid Films, Vol. 69, No. 1, June 1980, entitled "Electromigration in Gold and Copper Thin Film Conductors" by R. J. Miller, et al., analyses the electromigration behaviour of copper thin film conductors with chromium and niobium adhesion layers and of gold thin layers with zirconium and hafnium adhesion layers. It is disclosed that chromium adhesion layers do not affect the electromigration lifetime, whereas niobium layers reduce it. A structure consisting of a copper thin film sandwiched between upper and lower adhesion layers was used for the purpose of experiments.

Accordingly, a general object of the present invention is to provide a novel and useful method of producing a semiconductor device, in which the above problems have been eliminated.

A more specific object of the present invention is to provide a method of producing a semiconductor device, in which oxidation of a metallization film including at least copper is effectively prevented and its metallization resistance can be kept low even after deposition of an insulating layer.

Another object of the present invention is to provide a method of producing a semiconductor device, in which a copper interconnection of a low resistance is formed.

Still another object of the present invention is to provide a method of producing a semiconductor device, in which an electromigration is effectively suppressed.

According to the present invention, there is provided a method of producing a semiconductor device comprising the steps of depositing a diffusion barrier metallic film on an insulating film on a substrate, forming an alloy film including copper on said diffusion barrier metallic film, said alloy film comprising an alloy of copper and a material selected from the group consisting of titanium, zirconium, aluminium, boron and silicon, patterning said alloy film, and annealing said patterned alloy film in an ambient atmosphere including nitrogen gas in such a way as to diffuse atoms of said material toward top and side surfaces of the patterned alloy film and to combine said atoms of said material with nitrogen included in said ambient atmosphere, thereby forming a nitride film of said atoms of said material and an almost pure copper interconnection film the top and side surfaces of which are totally covered by said nitride film.

### BRIEF DESCRIPTION OF THE DRAWINGS

FIGS.1A through 1C are respectively cross sectional views for explaining an example of a method of producing a semiconductor device according to the present invention;
FIGS.2A and 2B are respectively cross sectional views for explaining steps for producing an alloy film;
FIGS.3A and 3B are respectively graphs showing experimental results for the measurement of the sheet resistivity;
FIGS.4A through 4C are respectively graphs showing experimental results for the measurement of the X-ray diffraction;
FIG.5A is a cross sectional view of an example of a semiconductor device produced by the method of the present invention;
FIG.5B is a cross sectional view along a line X-X in FIG.5A;
FIG.5C is a cross sectional view along a line Y-Y in FIG.5A; and

### DETAILED DESCRIPTION

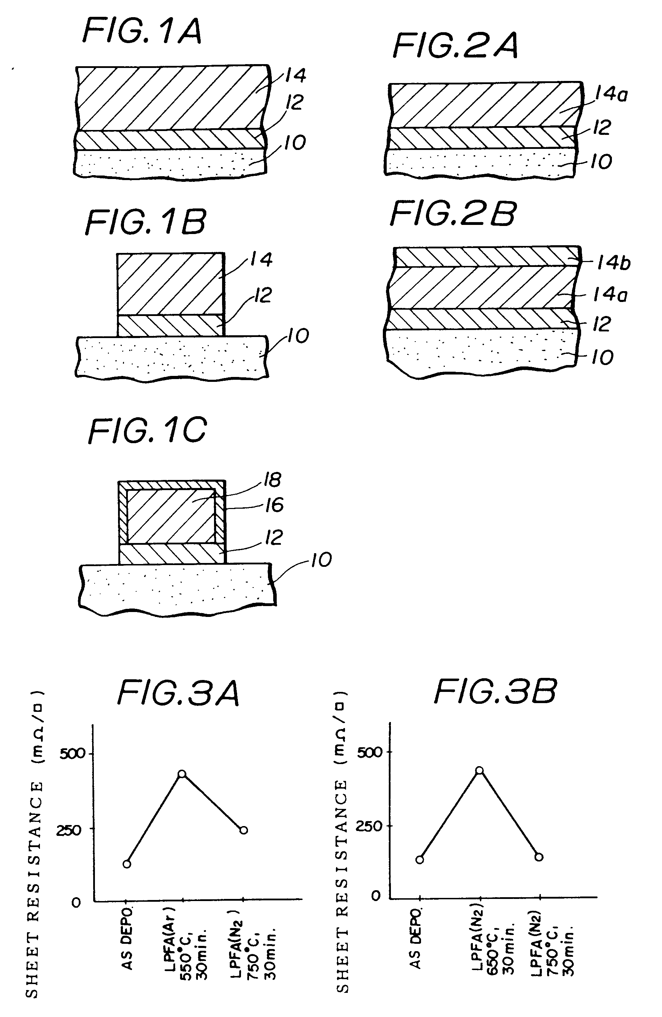

A description will first be given on a method of producing a semiconductor device which uses an alloy of copper and titanium (Cu-Ti alloy) for an interconnection film, by referring to FIGS.1A through 1C.

As shown in FIG.1A, an alloy film 14 consisting of Cu and Ti is deposited on a diffusion barrier metal film 12 which is deposited on an insulating film 10. The deposition of the Cu-Ti alloy may be carried out by a direct current (D.C.) magnetron sputtering method, in which a Cu-Ti alloy target is sputtered. The content of Ti in the Cu-Ti alloy film 14, which determines the thickness of a barrier film 16 for preventing Cu films from being oxidized, is preferably in the range from 1 to 40 weight %. The greater the content of Ti, the longer is the time required for growing the barrier film 16. The thickness of the Cu-Ti alloy film 14 preferably ranges from 0.3 µm to 2µm. The sputtering is carried out, for example, in an ambient atmosphere of argon (Ar) gas at a pressure of 0.67 Pa (5mTorr) with a power of D.C.4kw.

Another method for depositing the Cu-Ti alloy film 14 may be used instead of the above method using the Cu-Ti alloy target. That is, as shown in FIG.2A, a Cu film 14a is first deposited on the diffusion barrier metal film 12 by the D.C. magnetron sputtering in which a Cu target is sputtered. Then, as shown in FIG.2B, a Ti film 14b is deposited on the top of the Cu film 14a by the D.C. magnetron sputtering in which a Ti target is sputtered. Then, the Cu/Ti bilayer deposited on the barrier film 12 is annealed at a low pressure for alloying Cu with Ti to form the Cu-Ti alloy film 14 shown in FIG.1A. This low-pressure-furnaced annealing (abbreviated as LPFA) is carried out in Ar gas at 550°C, for example. The Ar gas acts to prevent Ti from being oxidized during annealing.

The diffusion barrier metal film 12 acts to prevent Cu atoms from reacting with and diffusing into the insulating film 10 made of phosphor-silicate glass (PSG), silicon dioxide (SiO₂) or silicon nitride (Si₃N₄), for example. The diffusion barrier metal film 12 may be made of titanium nitride (TiN), tungsten (W), tungsten nitride (WN), zirconium nitride (ZrN), titanium carbide (TiC), tungsten carbide (WC), tantalum (Ta), tantalum nitride (TaN) or titanium tungsten (TiW). The thickness of the diffusion barrier metal film 12 is preferably in the range from 100 to 200 nm (1,000Å to 2000Å). When using TiN to form the diffusion barrier metal film 12, for example, a reactive magnetron sputtering method may be used. The deposition of TiN is carried out in such a manner that a Ti target is sputtered in an ambient atmosphere of Ar+N₂ gas at a pressure of 0.67 Pa (5mTorr) with a power of D.C.4kW, for example.

Next, the Cu-Ti alloy film 14 thus deposited is patterned in accordance with an interconnection pattern by ion milling, as shown in FIG.1B. This ion milling process uses a SiO₂ mask or a PSG mask and is carried out in Ar gas at a pressure of 0.027 Pa (2x10⁻⁴Torr) with an accelerating voltage of 500V, for example. Instead of the ion milling, reactive ion etching (abbreviated as RIE), in which CCl₄+Cl₂ gas is used, may also be used for patterning.

Preferably, the diffusion barrier metal film 12 is also patterned after the patterning of the Cu-Ti alloy film 14. Since the diffusion barrier metal film 12 is provided to protect the diffusion of Cu atoms into the insulating film 10, the pattern of the diffusion barrier metal film 12 is made almost identical with the pattern of the Cu-Ti alloy film 14. The patterning of the diffusion barrier metal film 12 of TiN, for example, may be performed by the reactive ion etching method in an ambient atmosphere of SF₆ gas at a pressure of 2.7 to 6.7 Pa (0.02 to 0.05Torr) with a power of 50 to 200W, for example.

Then, the patterned Cu-Ti alloy film 14 is annealed. The annealing is carried out in an ambient atmosphere of nitrogen (N₂) gas at a temperature of 600 to 900°C for tens of minutes to a few hours. During annealing, Ti atoms are diffused toward top and side surfaces of the patterned film 14, and combined with N₂ in the atmosphere, so that the film 16 of TiN for oxidation resistance is formed on the top and side surfaces of the patterned film 14. With the out-diffusion of Ti atoms, the Cu atoms in the Cu-Ti alloy film 14 approach a pure state, so that there is finally formed an almost pure Cu film 18 which is covered by the TiN film 16. The Cu film 18 is an excellent interconnection film, because it is almost pure and thus its resistivity is kept extremely low. The thickness of the TiN film 16 depends on the annealing time and the content of Ti in the Cu-Ti film 14. Preferably, the TiN film 16 has the thickness 50 to 200 nm (500Å to 2,000Å). The aforementioned annealing is preferably carried out at a low pressure such as 530 Pa (4Torr). The gas for annealing is not limited to N₂ ambients, and gases including N₂ such as Ar+N₂ or NH₃(ammonia)+N₂ may be used.

The Cu interconnection film 18 is provided with oxidation resistance, since the top and side surfaces thereof are totally covered by the TiN film 16. In addition, since the Cu film 18 is deposited on the diffusion barrier metal film 12, the diffusion of Cu atoms into the insulating film 10 or a silicon substrate (not shown) through a contact hole (not shown) formed in the insulating film 10 is effectively prevented. As a result, even when an insulating film which acts as a layer-to-layer insulating film or a passivation film is deposited by means of the CVD at a temperature of approximately 420°C on the Cu film 18 which is covered by the TiN film 16, the oxidation of the Cu film 18 can be effectively prevented, so that the Cu interconnection layer of an extremely low resistance can be obtained. In addition, the generation of the electromigration in the Cu film 18 may be effectively prevented, since the Cu film 18 is formed by annealing at a high temperature in the range of 600 to 900°C. Therefore, the grain size grows larger.

A description will be given on a method of producing another semiconductor device in which a Cu interconnection film is totally covered by a barrier film of zirconium nitride (ZrN) which prevents the Cu interconnection film from being oxidized, by referring to FIGS.1A through 1C.

First, the alloy film 14 of Cu-Zr is deposited on the diffusion barrier metal layer 12. The deposition of the Cu-Zr alloy may be carried out by the D.C. magnetron sputtering method using a Cu-Zr alloy target. The content of Zr in the Cu-Zr alloy film 14, which determines the thickness of the barrier film 16 of ZrN, is preferably in the range from 1 to 40 weight %. The thickness of the Cu-Zr alloy film 14 ranges from 300 nm (3,000Å) to 2µm. The parameters for sputtering are the same as those when sputtering of the Cu-Ti target described.

The Cu-Zr alloy film 14 may also be formed by depositing a Cu/Zr bilayer on the diffusion barrier metal film 12 in that order and then carrying out the low-pressure annealing in N₂ gas at a temperature of 650°C, for example.

Steps following the deposition of the Cu-Zr alloy film 14 are performed in a similar way to the steps in the method of producing the Cu-Ti alloy film described previously. That is, the Cu-Zr alloy film 14 is patterned by means of ion milling. Then, the diffusion barrier metal film 12 is etched off by RIE. Finally, the patterned Cu-Zr alloy film 14 deposited on the patterned diffusion barrier metal film 12 is annealed, so that there is obtained the Cu film 18 totally covered by the ZrN film 16 which provides oxidation resistance for the Cu film 18.

The reason for use of Ti or Zr as explained in the foregoing is that the standard free generation energy thereof is relatively low and therefore nitride of Ti or Zr can easily be obtained. Instead of TiN or ZrN which is electrically conductive, an electrically insulating material of nitride such as BN, AlN or Si₃N₄ may be used to totally cover the top and side surfaces of the Cu interconnection film 18. A description will be given of the method of producing a semiconductor device, in which the Cu interconnection film is covered by such an insulating film, by using FIGS.1A through 1C.

As a first step, the alloy film 14 of Cu-Al, for example, is deposited on the top of the diffusion barrier metal film 12 made of TiN, TiW, W, ZrN, TiC, Ta TaN, TiW or WC by D.C. magnetron sputtering, in which a Cu-Al alloy target including Al of 1 to 40 weight % therein is sputtered. The sputtering is carried out in an ambient atmosphere of Ar gas at a pressure of 0.67 Pa (5mTorr) with a power of D.C.4kW, for example. The thickness of the Cu-Al film 14 is preferably in the range from 500 nm (5,000Å) to 2µm. Next, the Cu-Al alloy film 14 is patterned by ion milling etching, as shown in FIG.1B. The etching parameters are the same as those mentioned previously. Thereafter, the diffusion barrier metal film 12 is preferably patterned by RIE. Then, the patterned Cu-Al alloy film 14 is annealed in the atmosphere including N₂ gas at a low pressure. In detail, the annealing is carried out at a pressure of 530 Pa (4Torr) and a temperature of 600 to 900°C for 30 to 90 minutes. During annealing, Al atoms are diffused out and then react with N₂ in the atmosphere, so that the barrier film 16 of AlN which prevents the oxidation of Cu is formed on the top and side surfaces of an almost pure Cu interconnection film 18. The thickness of the AlN barrier film 16 preferably ranges from 30 to 150 nm (300Å to 1,500Å). Procedures for forming a BN or Si₃N₄ barrier film other than the AlN barrier film may be carried out in a similar way to the procedures for the AlN film.

A description will now be given of experimental results for the measurement of the sheet resistance of the interconnection film. In the experiment, two samples each having the barrier film 16 of TiN which were respectively formed by the following two different processes.

### Process 1

- Step 1:: The Cu film 14a (FIG.2A) of the thickness of 200 nm (2,000Å) was formed on the TiN film 12 by the D.C. magnetron sputtering, and then the Ti film 14b of the thickness of 150 nm (1,500Å) was deposited on the Cu film 14a by D.C. magnetron sputtering.
- Step 2:: Next, the Cu-Ti bilayer thus formed was annealed in Ar gas at a pressure of 530 Pa (4Torr) and a temperature of 550°C for 30 minutes in order to obtain the Cu-Ti alloy film 14.
- Step 3:: Then, the Cu-Ti alloy was annealed in N₂ gas at a pressure of 530 Pa (4Torr) and a temperature of 750°C for 30 minutes.

### Process 2

- Step 1:: The Cu film 14a (FIG.2A) of the thickness of 200 nm (2,000Å) was formed on the TiN film 12 by D.C. magnetron sputtering, and then the Ti film 14b of the thickness of 100 nm (1,000Å) was deposited on the Cu film 14a by D.C. magnetron sputtering.
- Step 2:: Next, the Cu-Ti bilayer thus formed was annealed in N₂ gas in a pressure of 530 Pa (4Torr) and a temperature of 650°C for 30 minutes in order to obtain the Cu-Ti alloy film 14.
- Step 3:: Then, the Cu-Ti alloy was annealed in N₂ gas at a pressure of 530 Pa (4Torr) and a temperature of 750°C for 30 minutes.

FIG.3A shows the sheet resistance (µΩ/□) of the conductor including Cu measured for each of the steps in process 1 above, and FIG.3B shows the sheet resistance (µΩ/□) measured for each of the steps in process 2 above. As shown in FIGS.3A and 3B, the sheet resistance measured after step 2 in each of the processes 1 and 2 is larger than that in the as-deposited state after step 1 in each of processes 1 and 2. This is because the Cu/Ti bilayer has been alloyed by annealing. However, the sheet resistance after step 3 in each of processes 1 and 2 decreases and is close to the sheet resistance after step 1. This means that the Cu-Ti alloy has been changed into almost pure Cu due to the out-diffusion of Ti, which reacts with N₂. This is supported by the X-ray diffraction experiments, which is described below. In FIG.3A, the sheet resistance after step 3 is slightly larger than that after step 1. This is because the annealing time of 30 minutes in step 3 was not sufficient to totally diffuse the Ti atoms toward the top and side surfaces of the Cu-Ti alloy film.

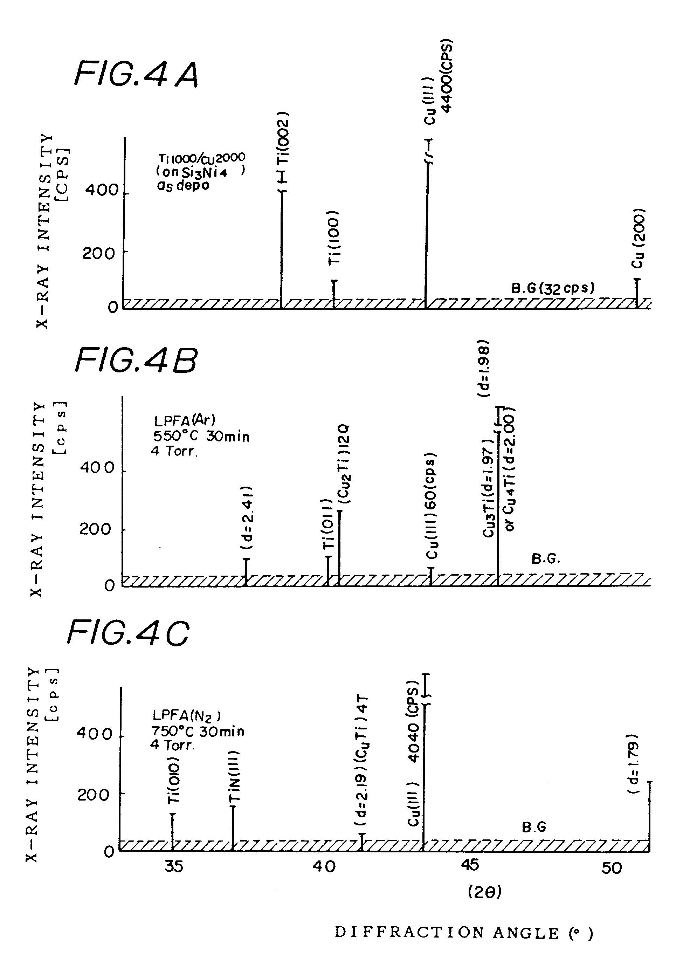

FIGS.4A through 4C respectively show the experimental results of the X-ray diffraction measurement. FIG.4A shows the results regarding an as-deposited Cu/Ti bilayer formed by depositing a Cu film of the thickness of 200 nm (2,000Å) on the Si₃N₄ insulating film and further depositing a Ti film of a thickness of 100 nm (1,000Å) on the Cu film. FIG.4B shows the results regarding the Cu-Ti alloy obtained by annealing the Cu/Ti bilayer in an ambient atmosphere of Ar gas at a pressure of 530 Pa (4Torr) and a temperature of 550°C for 30 minutes. FIG.4C shows the results regarding the Cu film covered by the TiN film obtained by annealing the Cu-Ti alloy in N₂ gas at a pressure of 530 Pa (4Torr) and a temperature of 750°C for 30 minutes. In FIG.4A, a very strong spectrum of Cu, especially the spectrum of (111) can be observed, whereas spectra of Cu₃Ti, Cu₄Ti and Cu₂Ti are notable in FIG.4B. This means that Cu atoms have been alloyed with Ti atoms. Further, very strong spectra of Cu and Ti can be observed in FIG.4C. This means that the film including Cu has been changed into an almost pure state after being annealed in N₂ gas.

A description will now be given of an example of a semiconductor device having a two-level metallization obtained in accordance with the method of the present invention.

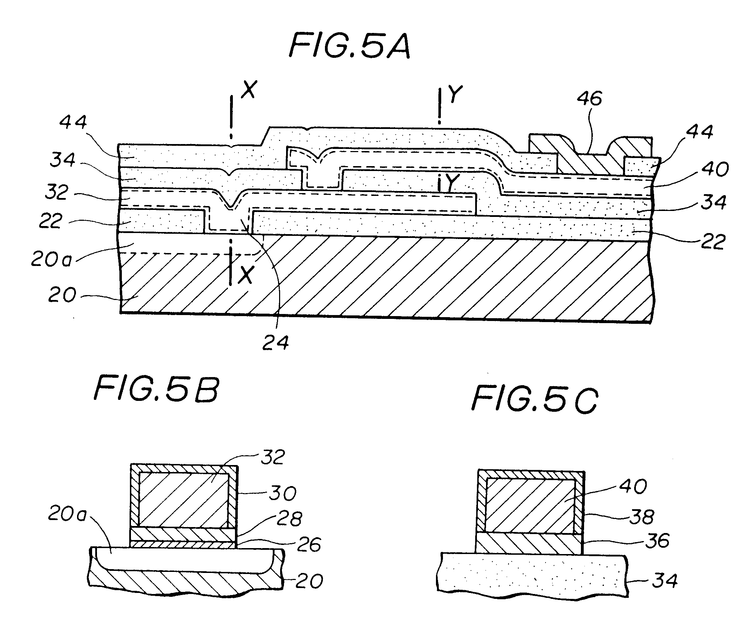

Referring to FIGS.5A through 5C, an insulating film 22 such as SiO₂ is deposited on a p-type of a Si substrate 20. The insulating film 22 is partially etched off to form a contact hole 24. On the insulating film 22 and over the contact hole 24, there are deposited a Ti film 26 of a thickness of 50 nm (500Å), a TiN diffusion barrier metal film 28 of a thickness of 100 nm (1,000Å) and an almost pure Cu interconnection film 32 in that order. The Ti film 26 is provided to make a better ohmic contact to a n⁺-diffused layer 20a formed in the Si substrate 20. The deposition of the Ti film 26 may be carried out by the D.C. magnetron sputtering in an ambient atmosphere of Ar gas at a pressure of 0.67 Pa (5mTorr) with a power of 2kW, for example. The deposition of the TiN film 28, a barrier film 30 of TiN and the almost pure Cu film 32 is performed in accordance with the method of the present invention discussed in the foregoing.

On the insulating film 22 and the almost pure Cu film 32 covered by the TiN film 30, there is deposited a layer-to-layer insulating film 34 such as PSG by the CVD. Although the temperature in the CVD process is approximately 420°C, the almost pure Cu film 32 is not oxidized because of the presence of the TiN film 30 which totally covers the almost pure Cu film 32. On the layer-to-layer insulating film 34, there is deposited a TiN barrier metal film 36 and an almost pure Cu interconnection film 40 which is totally covered by a TiN barrier film 38. This deposition is carried out in accordance with the method of the present invention described in the foregoing. The ohmic contact between the almost pure Cu film 32 at the first level and the almost pure Cu film 40 at the second level is formed through a contact hole 42 formed in the insulating film 34. It should be noted that a metallic film such as the Ti film 26 is not required because the bottom of the contact hole 42 is formed with the TiN film 36.

There is deposited a passivation film 44 on the insulating film 34 and the TiN film 38 by the CVD, for example. An Al bonding pad 46 for packaging is deposited on the top of the Cu film 40 covered by the TiN film 38. Although Al is liable to react with Cu, the illustrated structure can prevent the reaction, because the Cu film 40 is totally covered by the TiN film 38.

In the structure explained above, an Al film may be used instead of the TiN film 26, and W, WN, ZrN, TiC, Wc, Ta, TaN or TiW may be used instead of the TiN film 28 or 36. The insulating film 22, 34 or 44 may be formed by Si₃N₄ instead of SiO₂ or PSG. Moreover, the barrier film 30 or 38 may be formed by ZrN, AlN, BN or Si₃N₄. When using AlN, BN or Si₃N₄ to cover the Cu film 32 or 40, it is necessary to etch off the insulating film to form the through hole.

The present invention is not limited to the embodiments, but various variations and modifications may be made without departing from the scope of the present invention.

## Claims

1. A method of producing a semiconductor device comprising the steps of depositing a diffusion barrier metallic film (12) on an insulating film (10, 22) on a substrate (20), forming an alloy film (14) including copper (Cu) on said diffusion barrier metallic film, said alloy film comprising an alloy of copper and a material selected from the group consisting of titanium, zirconium, aluminium, boron and silicon, patterning said alloy film, and annealing said patterned alloy film in an ambient atmosphere including nitrogen (N₂) gas in such a way as to diffuse atoms of said material toward top and side surfaces of the patterned alloy film (14) and to combine said atoms of said material with nitrogen (N₂) included in said ambient atmosphere, thereby forming a nitride film (16) of said atoms of said material and an almost pure copper interconnection film (18) the top and side surfaces of which are totally covered by said nitride film (16).

2. A method of producing a semiconductor device as claimed in claim 1, wherein said step of annealing is performed at a reduced pressure.

3. A method of producing a semiconductor device as claimed in claim 1 or 2, wherein said step of annealing is performed at a temperature of 600 to 900°C.

4. A method of producing a semiconductor device as claimed in any of claims 1 to 3, wherein said step of annealing is performed for tens of minutes to a few hours.

5. A method of producing a semiconductor device as claimed in any of claims 1 to 4, wherein the thickness of said nitride film ranges from 50 to 100 nm (500 to 1000 Å).

6. A method of producing a semiconductor device as claimed in any of claims 1 to 5, wherein said ambient atmosphere is a gas including N atoms.

7. A method of producing a semiconductor device as claimed in any of claims 1 to 5, wherein said ambient atmosphere is a gas including N atoms and a gas selected from the group including argon (Ar) and ammonia (NH₃).

8. A method of producing a semiconductor device as claimed in any of claims 1 to 7, wherein said step of depositing said alloy film is performed by direct current magnetron sputtering in which an alloy including a Cu target is sputtered.

9. A method of producing a semiconductor device as claimed in any of claims 1 to 7, wherein said step of depositing said alloy is performed by depositing a bilayer film consisting of a Cu film (14a) and a metallic material (14b) which is alloyed with said Cu film on said substrate in that order and by annealing said bilayer film.

10. A method of producing a semiconductor device as claimed in any of claims 1 to 9, wherein the thickness of said alloy film ranges from 300 nm (3000 Å) to 2 µm.

11. A method of producing a semiconductor device as claimed in any of claims 1 to 10, wherein a metallic material other than Cu is included as 1 to 20 weight percent in said alloy film.

12. A method of producing a semiconductor device as claimed in any of claims 1 to 11, wherein said step of patterning is carried out by an ion milling method.

13. A method of producing a semiconductor device as claimed in any of claims 1 to 12, wherein said method further comprises a step of depositing an insulating film on said Cu interconnection film covered by said nitride.

14. A method of producing a semiconductor device as claimed in any of claims 1 to 13, wherein said deposition of said insulating film is carried out by chemical vapour deposition (CVD).

15. A method of producing a semiconductor device as claimed in any preceding claim, wherein said diffusion barrier metallic film (12) comprises a material selected from the group consisting of titanium nitride, tungsten, tungsten nitride, zirconium nitride, titanium carbide, tungsten carbide, tantalum, tantalum nitride and titanium tungsten.

## Patentansprüche

1. Verfahren zur Herstellung einer Halbleiteranordnung, mit den Schritten: Abscheiden eines Diffusionsbarrieren-Metallfilms (12) auf einem Isolierfilm (10, 22) auf einem Substrat (20), wobei ein Kupfer (Cu) enthaltender Legierungsfilm (14) auf dem genannten Diffusionsbarrieren-Metallfilm gebildet wird, welcher Legierungsfilm eine Legierung aus Kupfer und einem Material, ausgewählt aus der Gruppe bestehend aus Titan, Zirkonium, Aluminium, Bor und Silizium, enthält; Mustern des genannten Legierungsfilms und Ausheilen des genannten gemusterten Legierungsfilms in einer Stickstoff (N₂)-Gas enthaltenden Umgebungsatmosphäre derart, daß Atome des genannten Materials zu oberen und seitlichen Flächen des gemusterten Legierungsfilms (14) diffundieren und die genannten Atome des genannten Materials mit in der genannten Umgebungsatmosphäre enthaltenem Stickstoff (N₂) kombinieren, wodurch ein Nitridfilm (16) der genannten Atome des genannten Materials und ein Zwischenverbindungsfilm (18) aus nahezu reinem Kupfer gebildet werden, dessen obere und seitliche Flächen vollständig von dem genannten Nitridfilm (16) bedeckt sind.

2. Verfahren zur Herstellung einer Halbleiteranordnung nach Anspruch 1, bei welchem der genannte Schritt des Ausheilens bei vermindertem Druck durchgeführt wird.

3. Verfahren zur Herstellung einer Halbleiteranordnung nach Anspruch 1 oder 2, bei welchem der genannte Schritt des Ausheilens bei einer Temperatur von 600 bis 900°C durchgeführt wird.

4. Verfahren zur Herstellung einer Halbleiteranordnung nach einem der Ansprüche 1 bis 3, bei welchem der genannte Schritt des Ausheilens zehn Minuten bis einige Stunden lang durchgeführt wird.

5. Verfahren zur Herstellung einer Halbleiteranordnung nach einem der Ansprüche 1 bis 4, bei welchem die Dicke des genannten Nitridfilms im Bereich von 50 bis 100 nm (500 bis 1000 Å) liegt.

6. Verfahren zur Herstellung einer Halbleiteranordnung nach einem der Ansprüche 1 bis 5, bei welchem die genannte Umgebungsatmosphäre ein N-Atome enthaltendes Gas ist.

7. Verfahren zur Herstellung einer Halbleiteranordnung nach einem der Ansprüche 1 bis 5, bei welchem die genannte Umgebungsatmosphäre ein N-Atome enthaltendes Gas und ein Gas, ausgewählt aus der Gruppe enthaltend Argon (Ar) und Ammoniak (NH₃), ist.

8. Verfahren zur Herstellung einer Halbleiteranordnung nach einem der Ansprüche 1 bis 7, bei welchem der genannte Schritt des Abscheidens des genannten Legierungsfilms durch Gleichstrom-Magnetron-Zerstäubung durchgeführt wird, bei der eine ein Cu-Target enthaltende Legierung zerstäubt wird.

9. Verfahren zur Herstellung einer Halbleiteranordnung nach einem der Ansprüche 1 bis 7, bei welchem der genannte Schritt des Abscheidens der genannten Legierung durch Abscheiden eines zweischichtigen Films, bestehend aus einem Cu-Film (14a) und einem metallischen Material (14b), das mit dem genannten Cu-Film auf dem genannten Substrat in dieser Reihenfolge legiert wird, und durch Ausheilen des genannten zweischichtigen Films durchgeführt wird.

10. Verfahren zur Herstellung einer Halbleiteranordnung nach einem der Ansprüche 1 bis 9, bei welchem die Dicke des genannten Legierungsfilms im Bereich von 300 nm (3000 Å) bis 2 µm liegt.

11. Verfahren zur Herstellung einer Halbleiteranordnung nach einem der Ansprüche 1 bis 10, bei welchem ein anderes metallisches Material als Cu als 1 bis 20 Gewichtsprozent in dem genannten Legierungsfilm enthalten ist.

12. Verfahren zur Herstellung einer Halbleiteranordnung nach einem der Ansprüche 1 bis 11, bei welchem der genannte Schritt des Musterns durch ein Ionenmilling-Verfahren durchgeführt wird.

13. Verfahren zur Herstellung einer Halbleiteranordnung nach einem der Ansprüche 1 bis 12, bei welchem das genannte Verfahren ferner einen Schritt des Abscheidens eines Isolierfilms auf dem genannten Cu-Zwischenverbindungsfilm, der durch das genannte Nitrid bedeckt ist, umfaßt.

14. Verfahren zur Herstellung einer Halbleiteranordnung nach einem der Ansprüche 1 bis 13, bei welchem die genannte Abscheidung des genannten Isolierfilms durch chemische Dampfabscheidung (CVD) durchgeführt wird.

15. Verfahren zur Herstellung einer Halbleiteranordnung nach einem der vorhergehenden Ansprüche, bei welchem der genannte Diffusionsbarrieren-Metallfilm (12) ein Material, ausgewählt aus der Gruppe bestehend aus Titannitrid, Wolfram, Wolframnitrid, Zirkoniumnitrid, Titancarbid, Wolframcarbid, Tantal, Tantalnitrid und Titanwolfram, enthält.

## Revendications

1. Un procédé de fabrication d'un dispositif à semiconducteurs comprenant les étapes qui consistent à déposer une pellicule métallique de barrière de diffusion (12) sur une pellicule isolante (10, 22) sur un substrat (20), à former une pellicule d'alliage (14) contenant du cuivre (Cu) sur la pellicule métallique de barrière de diffusion, cette pellicule d'alliage comprenant un alliage de cuivre et d'un matériau sélectionné dans le groupe qui comprend le titane, le zirconium, l'aluminium, le bore et le silicium, à définir un motif dans la pellicule d'alliage et à recuire la pellicule d'alliage portant un motif, dans une atmosphère ambiante contenant un gaz consistant en azote (N₂), de manière à faire diffuser des atomes du matériau précité vers les surfaces supérieure et latérales de la pellicule d'alliage portant un motif (14), et à combiner ces atomes du matériau avec l'azote (N₂) qui est contenu dans l'atmosphère ambiante, pour former ainsi une pellicule de nitrure (16) des atomes précités du matériau, et une pellicule d'interconnexion en cuivre presque pur (18) dont les surfaces supérieure et latérales sont totalement recouvertes par la pellicule de nitrure (16).

2. Un procédé de fabrication d'un dispositif à semiconducteurs selon la revendication 1, dans lequel l'étape de recuit est effectuée à une pression réduite.

3. Un procédé de fabrication d'un dispositif à semiconducteurs selon la revendication 1 ou 2, dans lequel l'étape de recuit est effectuée à une température de 600 à 900°C.

4. Un procédé de fabrication d'un dispositif à semiconducteurs selon l'une quelconque des revendications 1 à 3, dans lequel l'étape de recuit est effectuée pendant une durée allant de quelques dizaines de minutes à quelques heures.

5. Un procédé de fabrication d'un dispositif à semiconducteurs selon l'une quelconque des revendications 1 à 4, dans lequel l'épaisseur de la pellicule de nitrure est comprise entre 50 et 100 nm (500 à 1000 Å).

6. Un procédé de fabrication d'un dispositif à semiconducteurs selon l'une quelconque des revendications 1 à 5, dans lequel l'atmosphère ambiante est formée par un gaz contenant des atomes de N.

7. Un procédé de fabrication d'un dispositf à semiconducteurs selon l'une quelconque des revendications 1 à 5, dans lequel l'atmosphère ambiante est formée par un gaz contenant des atomes de N et un gaz sélectionné dans le groupe qui comprend l'argon (Ar) et l'ammoniac (NH₃).

8. Un procédé de fabrication d'un dispositif à semiconducteurs selon l'une quelconque des revendications 1 à 7, dans lequel l'étape de dépôt de la pellicule d'alliage est effectuée par pulvérisation cathodique par magnétron à courant continu, dans laquelle on pulvérise un alliage contenant une cible en Cu.

9. Un procédé de fabrication d'un dispositif à semiconducteurs selon l'une quelconque des revendications 1 à 7, dans lequel l'étape de dépôt de l'alliage est effectuée en déposant une pellicule à deux couches qui consiste en une pellicule de Cu (14a) et en un matériau métallique (14b) qui est allié avec la pellicule de Cu sur le substrat, dans cet ordre, et en recuisant la pellicule à deux couches.

10. Un procédé de fabrication d'un dispositif à semiconducteurs selon l'une quelconque des revendications 1 à 9, dans lequel l'épaisseur de la pellicule d'alliage est comprise entre 300 nm (3000 Å) et 2 µm.

11. Un procédé de fabrication d'un dispositif à semiconducteurs selon l'une quelconque des revendications 1 à 10, dans lequel un matériau métallique autre que Cu est inclus dans la pellicule d'alliage dans une proportion de 1 à 20% en masse.

12. Un procédé de fabrication d'un dispositif à semiconducteurs selon l'une quelconque des revendications 1 à 11, dans lequel l'étape de définition de motif est accomplie par un procédé d'érosion ionique.

13. Un procédé de fabrication d'un dispositif à semiconducteurs selon l'une quelconque des revendications 1 à 12, ce procédé comprenant en outre une étape qui consiste à déposer une pellicule isolante sur la pellicule d'interconnexion en Cu recouverte par le nitrure.

14. Un procédé de fabrication d'un dispositif à semiconducteurs selon l'une quelconque des revendications 1 à 13, dans lequel le dépôt de la pellicule isolante est accompli par dépôt chimique en phase vapeur (CVD).

15. Un procédé de fabrication d'un dispositif à semiconducteurs selon l'une quelconque des revendications précédentes, dans lequel la pellicule métallique de barrière de diffusion (12) consiste en un matériau qui est sélectionné dans le groupe comprenant le nitrure de titane, le tungstène, le nitrure de tungstène, le nitrure de zirconium, le carbure de titane, le carbure de tungstène, le tantale, le nitrure de tantale et le titane-tungstène.
